# EUROPEAN PATENT APPLICATION

(11) **EP 4 486 079 A1**
(43) Date of publication of application: **01.01.2025**
(21) Application number: 24172012.7
(22) Date of filing: 23.04.2024
(51) Int. Cl.: H05K 5/00

(54) **AN ELECTRONIC ASSEMBLY WITH SEALED ELECTRICAL CONNECTOR**

(30) Priority: 26.06.2023 US 202363510265 P; 22.09.2023 US 202318472758
(71) Applicant: Deere & Company, Moline, IL 61265 (US)
(72) Inventor: Brandt, Patrick R., Fargo, 58102 (US); Roan, Thomas J., Fargo, 58102 (US); Lind, Stephen P., Fargo, 58102 (US); Erickson, Shane K., Fargo, 58102 (US); Amundson, Roger K., Fargo, 58102 (US)
(74) Representative: Reddie & Grose LLP

(57) **Abstract**

An electronic assembly comprises a first housing portion and a second housing portion coupled to the first housing portion to form a cavity. A circuit board resides within the cavity. The second housing portion has a connector body with a hollow core, where the connector body extends outward from the second housing portion. The connector body has walls with a corresponding wall mating surface that faces a respective circuit-board mating surface of the circuit board. An adhesive sealant is configured to adhere to the wall mating surface and the circuit-board mating surface.

## Description

### Related Application

This application claims priority to U.S. provisional application number 63/510,265, filed June 26, 2023, where the above application is hereby incorporated by reference herein.

### Field

This disclosure relates to an electronic assembly with a sealed electrical connector.

### Background

In some prior art, a reliable sealed electrical connector can prevent moisture, water, salt, debris or other contamination from migrating into a housing of an electronic assembly, where the moisture, salt, contamination can detrimentally impact the reliability of the circuit board, electrical components, and electronic components. For example, if a mating connector (e.g., plug or socket) of a cable, cord, conductor or wiring harness is normally, continuously connected with a corresponding electrical connector of the electronic assembly, the mated connectors may provide a suitable seal. However, in the absence of the mating connector or during an unmated state, the electrical connector may be vulnerable to the ingress of moisture, water, salt or debris into the housing, which could temporarily or permanently disrupt normal operation of the electronic assembly. Accordingly, there is need for an electronic assembly with a sealed electrical connector (e.g., in its unmated state or disconnected state) to prevent possible damage to the electronics within the housing of an electronic assembly.

### Summary

In accordance with one embodiment, an electronic assembly comprises a first housing portion and a second housing portion coupled to the first housing portion to form a cavity. A circuit board resides within the cavity. The second housing portion has a connector body with a hollow core, where the connector body extends outward from the second housing portion. The connector body has walls with a corresponding wall mating surface that faces a respective circuit-board mating surface of the circuit board. An adhesive sealant is configured to adhere to the wall mating surface and the circuit-board mating surface.

### Brief Description of the Drawings

FIG. 1 is a perspective view of an upper side of a first embodiment of an electronic assembly.
FIG. 2 is a perspective view of an upper side of a first embodiment of the electronic assembly with a portion cut-away.
FIG. 3 is an exploded perspective view of a lower side of a first embodiment of the electronic assembly.
FIG. 4 is an exploded perspective view of an upper side of a first embodiment of the electronic assembly.
FIG. 5 is a cross-section of a first embodiment of an electronic assembly along reference line 5-5 of FIG. 1.

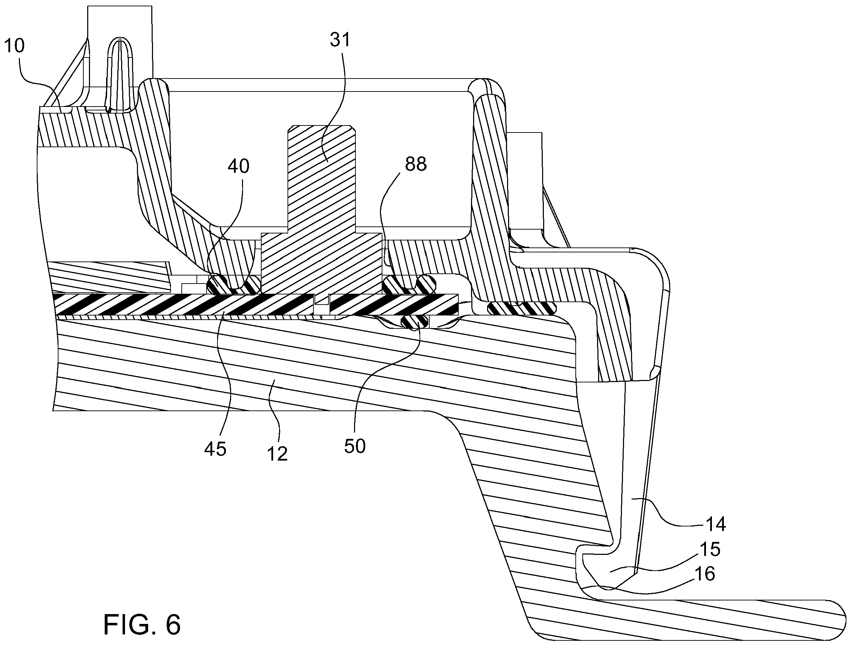

FIG. 6 is an enlarged view of the right side of the cross-section of FIG. 5.

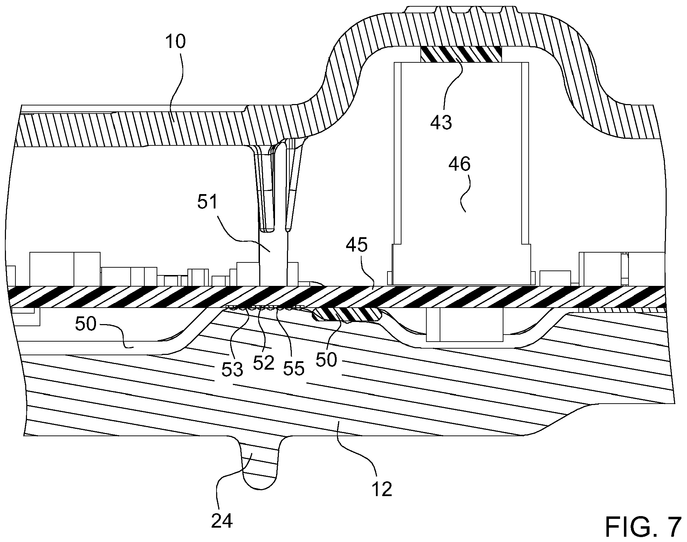

FIG. 7 is an enlarged view a central region of the cross-section of FIG. 5.
FIG. 8 is a perspective view of the interior of a second housing portion of FIG. 1.
FIG. 9 is a perspective view of an upper side of a second embodiment of the electronic assembly.
FIG. 10 is a perspective view of an upper side of a second embodiment of the electronic assembly with the electronic assembly cutaway to reveal the circuit board.
FIG. 11 is a cross-section of a second embodiment of an electronic assembly along reference line 11-11 of FIG. 10.
FIG. 12 is a perspective view of an upper side of a third embodiment of the electronic assembly with the electronic assembly cutaway to reveal the circuit board.
FIG. 13 is a cross-section of a second embodiment of an electronic assembly along reference line 13-13 of FIG. 12.
FIG. 14 discloses one embodiment of a flow chart for a method of making an electronic assembly with a sealed electrical connector.

Like reference numbers in any set of two or more drawings indicates like elements, features or steps.

### Detailed Description

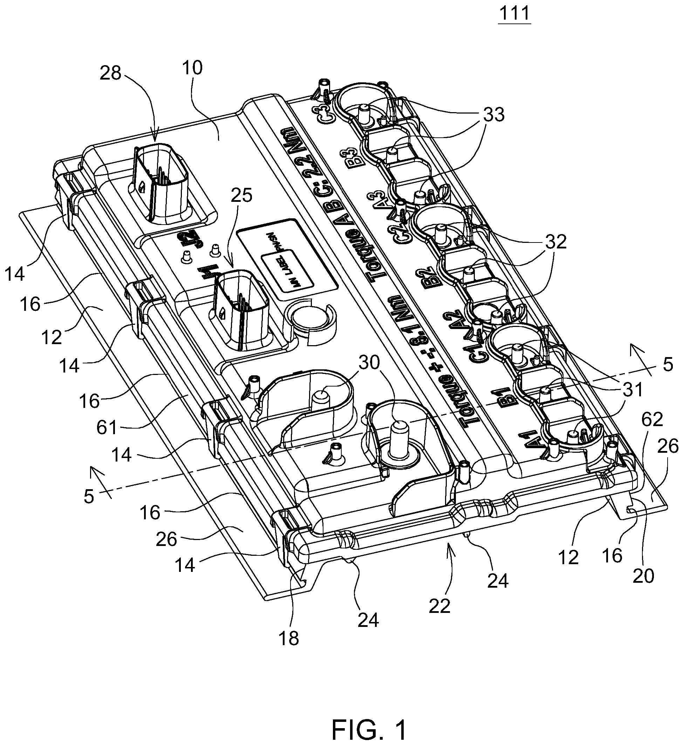

In accordance with one embodiment, FIG. 1 illustrates a perspective top view of an electronic assembly 111 that comprises a first housing portion 12 having one or more recesses 16 along at least a portion of an outer perimeter surface 17 of the first housing portion 12. A second housing portion 10 has one or more arms 14 extending from a body of the second housing portion 10 that terminate in mating protrusions 15. One or more arms 14, or one or more mating protrusions 15, or both, engage the recesses 16 (e.g., grooves) in a snap-fit connection of a snap-fit connector 19 or a mechanical clip.

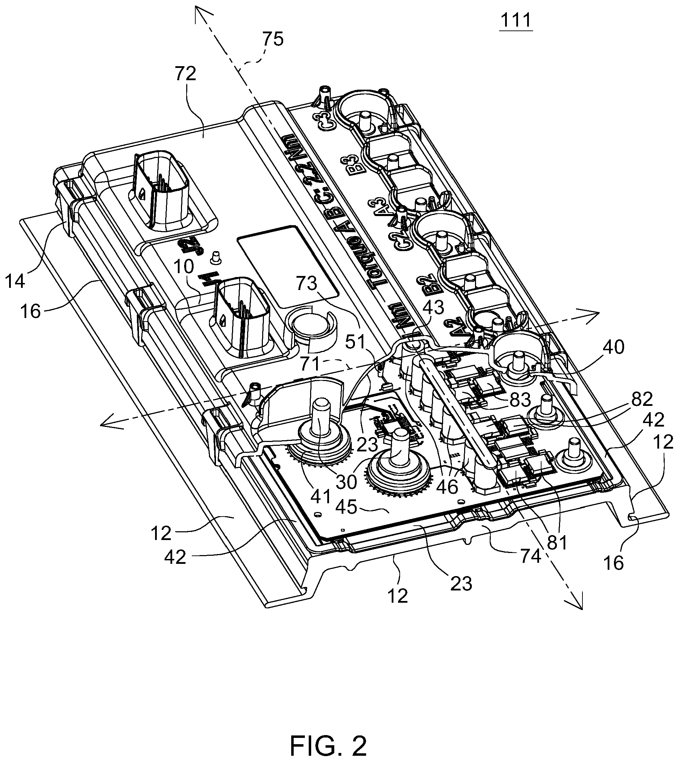

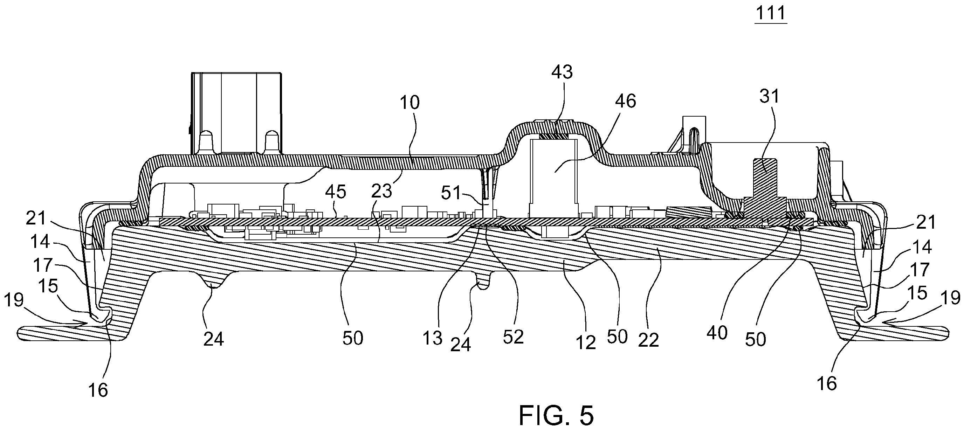

A cavity 23 is formed between the first housing portion 12 and the second housing portion 10. In FIG. 2, the second housing portion 10 is cut away to reveal a circuit board 45 that resides in the cavity 23; as illustrated in the cross-section of FIG. 5, the circuit board 45 has a conductive trace 52 (e.g., metallic pad) that faces the first housing portion 12 at a metallic conductive region 13, wherein the snap-fit connector 19 or mechanical clip forms an electrical and mechanical connection between the conductive trace 52 and the metallic conductive region 13.

In one embodiment, the snap-fit connector 19 comprises a combination of the snap-fit arms 14, mating protrusions 15 and respective recesses 16 to secure or removably connect the first housing portion 12 to the second housing portion 10. Further, the snap-fit connector 19 or its snap-fit arms 14 provide a compressive force or clamping force between the conductive trace 52 and the metallic conductive region 13, while the snap-fit connector 19 securely or removably connects the first housing portion 12 to the second housing portion 10.

In an alternate embodiment, one or more snap-fit connectors 19 may be replaced by a hinged compression clamp, such as a toggle latch clamp, that is mounted on the exterior sides of one housing portion (e.g., 10, 110, 12, 112) to engage a catch or projection on an opposite housing portion of the electronic assembly (111, 211). For example, the hinged compression clamp has a stationary base that is mounted (e.g., fastened) to one housing portion and a stationary catch that is mounted (e.g., fastened) to the opposite housing portion, where the stationary base has a lever that is pivotally or rotatably mounted to the stationary base via first hinge. Meanwhile the lever has a latch or latching member that is pivotally or rotatably mounted to the lever via a second hinge, where the latching member terminates in a hook that can engage the catch to clamp, secure, or lock together the housing portions (e.g., 10 and 12, or 110 and 112) of the electronic assembly (111, 211).

In one embodiment, the first housing portion 12 comprises a metallic base with an exterior surface 22. For example, the first housing portion 12 is formed of extruded metal or an extruded alloy and has set of longitudinal ridges 24 on the exterior surface 22, where the longitudinal ridges 24 can add structural integrity and can promote heat dissipation of heat-generating components. The first housing portion 12 is formed of a extruded metal or an alloy and has a set of longitudinal ridges 24 and a foot 26 portion.

Alternately, the first housing portion 12 may be cast of metal or an alloy, or molded from plastic, polymer, or composite material with surface metallization to form conductive region (e.g., metallic conductive region 13) that interfaces with the conductive trace 52 (e.g., metallic pad) of the circuit board 45.

In the electronic assembly 111, one or more heat-generating components are mounted on one or both sides of the circuit board 45. For example, heat-generating components comprise capacitors 46, semiconductor switches (81, 82, 83), and other electrical or electronic devices of the electronic assembly 111

The second housing portion 10 comprises a lid, wherein the lid is composed of a plastic, a polymer, or a composite material. For example, for a composite material, the lid may be formed of plastic or polymer matrix with a filler, such as carbon fiber, fiberglass, or the like. In one embodiment, the arms 14 (of the second housing portion 10), or both the arms 14 and the mating protrusions 15, are composed of a somewhat flexible or elastically deformable plastic, a polymer or a composite material to support the snap-fit connector 19.

In one embodiment, the one or more recesses 16 comprises a first groove in a corresponding first exterior side 61 (e.g., first exterior wall 18) of the first housing portion 12 and a second groove in a corresponding second exterior side 62 of the first housing portion 12, where the first exterior side 61 is opposite the second exterior side 62 (e.g., second exterior wall 20).

Each arm 14 terminates in a protrusion 15 that is of a size and shape to engage or mate with a corresponding recess 16 (e.g., groove or slot) in the second housing portion 10. Each recess 16 (e.g., groove) has a cross-section or profile that is configured to receive the protrusion 15 at the end of the respective arm 14. Further, each arm 14 can elastically deform prior to engaging the corresponding recess 16 (e.g., groove). As shown in FIG. 5, the outer perimeter surface 17 of the first housing portion 12 is generally tapered downward and outward such that the elastic deformation of each arm 14 is greatest during assembly and prior to the mating protrusion's engaging or interlocking with the recess 16 (e.g., groove).

Further, the air gap 21 between the outer perimeter surface 17 and arm 14 supports removal of the second housing portion 10 from the first housing portion 12, or vice versa, by allowing the end user to insert a tool (e.g., a screwdriver or pry bar) in the air gap to elastically withdraw the protrusion 15 from the recess 16, while elastically, temporarily deforming an arm 14 such that the protrusion 15 can clear the perimeter surface of the first housing portion 12.

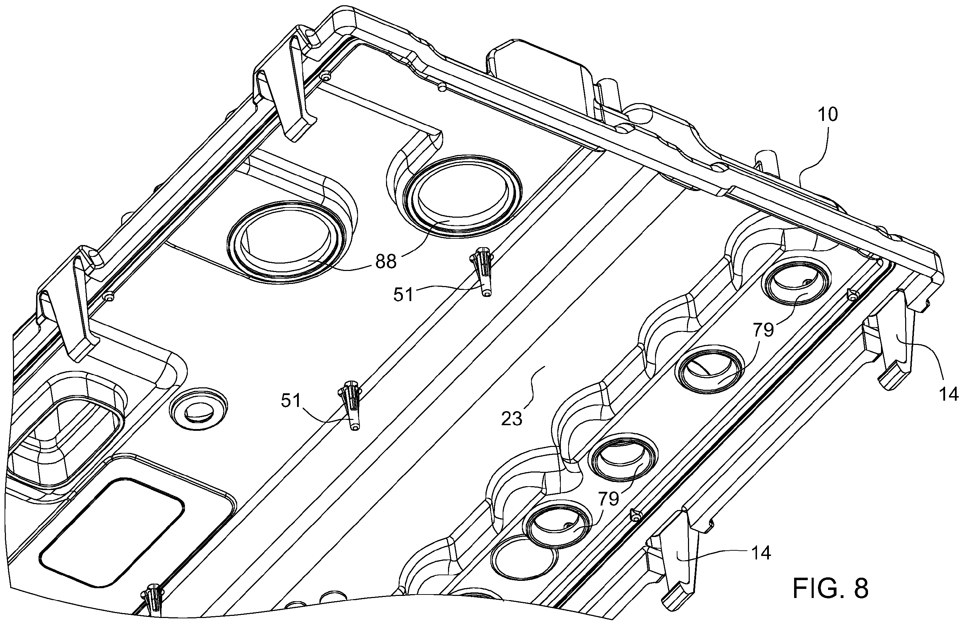

In one embodiment, the second housing portion 10 has a first array of arms 14 that extend (e.g., downward in FIG. 1 and FIG. 8) from the second housing portion 10 to engage one or more respective recesses 16, such as a first groove or first set of grooves that are spaced apart from each other. Meanwhile, the second housing portion 10 has a second set of arms 14 extending (e.g., downward in FIG. 1 and FIG. 8) from the second housing portion 10 to engage one or more recesses 16, such as the second groove, or second set of grooves that are spaced apart from each other. For example, as illustrated in FIG. 1, the recesses 16 in the first housing portion 12 comprise a continuous first groove and a second groove, where each groove has cross section (e.g., upper surface or lip) that can receive the tab, projection, or hook.

In an alternate embodiment, the recesses 16 in the first housing portion 12 may comprise discontinuous set for first grooves and a discontinuous set of second grooves.

The second housing portion 10 has a projection or post 51 that extends (e.g., downward) in the cavity 23 and above the circuit board 45. In one embodiment, the second housing portion 10 has a projection or post 51 that contacts an opposite side of the circuit board 45 opposite the conductive trace 52, and wherein the first housing portion 12 has conductive protrusion (e.g., conductive ridge) associated with the metallic conductive region 13 to contact the conductive trace 52 on the circuit board 45. For example, the conductive protrusion or conductive ridge of the first housing portion 12 may be formed of solder, such as solder that was applied and reflowed prior to assembly of the circuit board 45 within the cavity of the enclosure established by mating the first housing portion 12 with the second housing portion 10. In one embodiment, the post 51 projects downward: (a) to an extent that is greater than a gap or spacing between an lower interior surface of the second housing portion 10 and the top or upper surface of the circuit board 45, (b) to an extent that causes physical interference between the printed circuit board (45, 145) and its upper surface, or both to cause the second housing portion 10 to be preloaded with a biasing force to clamp or compress the conductive trace or conductive pad (opposite the contact point of the post 51) on the circuit board 45 toward the conductive protrusion of the interior of the first housing portion 12 (e.g., when the second housing portion 10 is fully engaged or connected to the first housing portion 12). The arms 14 that terminate in protrusions 15 form a snap-fit connector 19 or clips that allow the center of the second housing portion 10 to be spring-like biased or preloaded along the central axis or longitudinal axis 75 of the second housing portion 12.

Prior to fastening the first housing portion 12 and the second housing portion 10 via one or more snap-fit connectors 19, the second housing portion 10 comprises a cover or lid that is convex or arched downward toward the first housing portion 12. The second housing portion is configured or designed to apply a compressive or clamping force to the circuit board (45, 145). The compressive or clamping force to the circuit board (45, 145) is applied via the second housing portion 10 to cause potentially the solder to deform. The second housing portion has sufficient strength, flexibility and resilience to maintain contact between the conductive trace of the circuit board 45, the solder and the enclosure of the electronic assembly 111.

In alternative embodiment, which is explained with reference to FIG. 2, prior to connecting the first housing portion 12 and the second housing portion 10 together, the second housing portion 10 may be arched downward (e.g., convexly preloaded with resilient bias) along a transverse axis 71 and above the post 51 near central portion 73 of the second housing portion 10 (e.g., with integral spring-like bias) from which the post 51 extends downwards. For example prior to engagement or locking of the first housing portion 12 to the second housing portion 10 a clearance gap may exist between them at opposite sides (72, 74). However, when or while the second housing portion 10 is fully connected to the first housing portion 12 via the snap-fit connectors 19 the second housing portion 10 is elastically deformed or biased (compressively) such that one or more of the following occurs: (a) the clearance gap disappears, where the mating portions of the second housing portion 10 is generally planar and conforms to the first housing portion 12 (e.g., at sides (72, 74); (b) the second housing portion 10 unfolds about the transverse axis 71 to eliminate any appearance of convexity or the clearance gap, (c) the second housing portion 10 is configured to apply compressive force or clamping force between an opposite side of the circuit board 45 opposite conductive trace 52 and the metallic conductive region 13. The above convexity can be applied to one or more posts 51 near or around the central portion of the second housing portion 10.

In yet another alternative embodiment, the solder of the metallic conductive region is associated with the solder flow through the circuit board (45, 145) during reflow in an oven to creating a solder icicle on one side (e.g., lower side) of the circuit board (45, 145). For example, the alternative embodiment, would be a design improvement for any circuit board that is manufactured or made through a single-sided reflow.

As illustrated in FIG. 5, the conductive trace 52 on the circuit board 45 and the first housing portion 12 are electrically grounded through the above electrical and mechanical contact between the conductive trace 52 and the metallic conductive region 13 or conductive protrusion associated with the metallic conductive region 13. The conductive ridge comprises a solder bump. The conductive ridge comprises one or more of the following: a generally planar surface, a wavy, stippled, or grooved surface. For example, in one embodiment, the conductive ridge has a wavy surface in which rows of peaks 53 that are separated by intervening valleys 55.

In FIG. 2, first semiconductor switches 81 may comprise a first pair of a low-side semiconductor switch and a high-side semiconductor switch. A second pair of semiconductor switches 82 may comprise a second pair of a low-side semiconductor switch and a high-side semiconductor switch. A third pair of semiconductor switches 83 may comprise a third pair of a low-side semiconductor switch and a high-side semiconductor switch.

As illustrated in FIG. 2, FIG. 3, and FIG. 4, dielectric seals or dielectric sealant is applied, dispensed, placed, or configured for the corresponding target areas of a first volume or first region 47 between the second housing portion 10 and the circuit board 45, and for the corresponding target areas of a second volume or second region 50. In one embodiment, the dielectric seals or dielectric sealant comprises a thermally conductive material, with a thermal conductivity that exceeds a threshold. In one configuration, the dielectric seals or dielectric sealant may comprise an elastomer, a polymeric adhesive, a latex adhesive or another suitable materials that bond to, adhere to, overlie, contact or interface with one or more of the following: the first housing portion 12, the second housing portion 10, the circuit board 45 or heat-generating components associated with the circuit board 45 or the electronic assembly 111. For example, the dielectric seals or dielectric sealant may form a barrier (e.g., by elastic compression of the dielectric seals or sealant by the snap-fit connector 19, fasteners or attachment, alone or in combination with adhesive bonding or adhesion) to the ingress of moisture, salt, fog, contaminants or debris from entering the cavity 23 formed by the first housing portion 12 connected to the second housing portion 10.

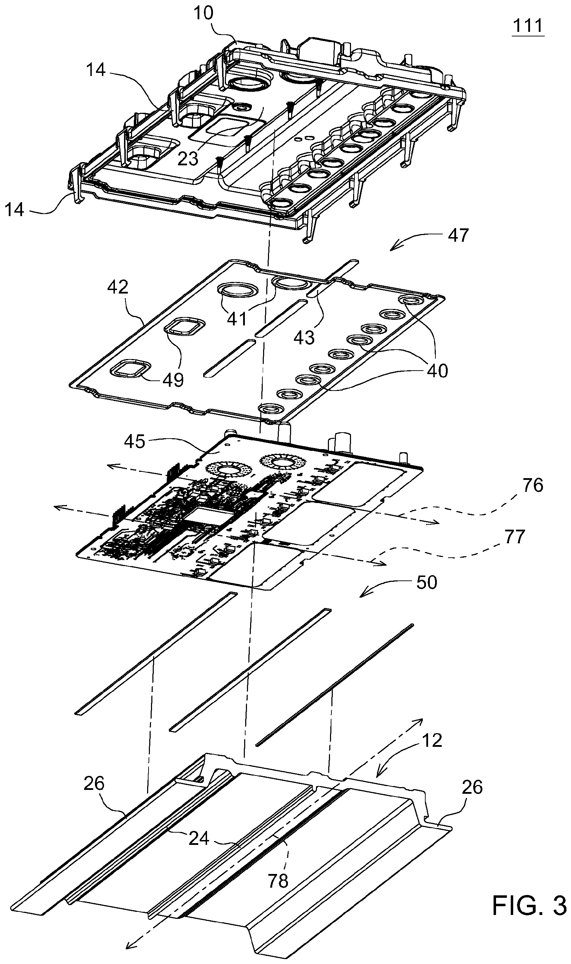

As illustrated in FIG. 3, for the first region 47, the dielectric seals or dielectric sealant comprises one or more of the following seals: one or more first rings 41, one or more second rings 40, a housing perimeter barrier 42, an adhesive sealant 49 (or connector seal), and component thermal interface material 43. For the second region 50, the dielectric seals or dielectric sealant comprises a thermally conductive interface, such as a board thermal conductive interface material that can conduct (efficiently) heat from heat-generating component or from the circuit board to the first housing portion 12, the second housing portion 10, or both.

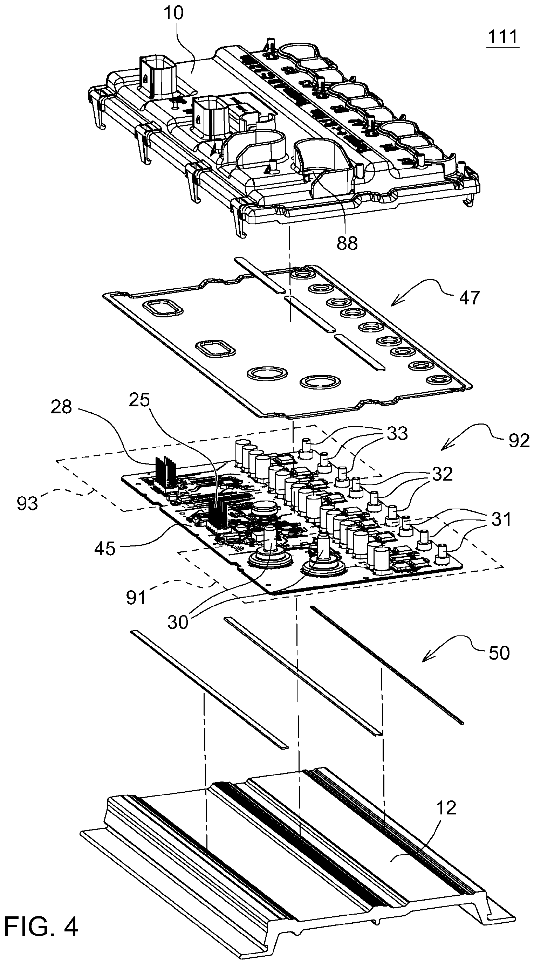

In FIG. 4, the circuit board 45 comprises a first power electronics module 91 within a first region of the circuit board 45, a second power electronics module region 92 within a second region of the circuit board 45, and a third power electronics module region 93 within a third region of the circuit board 45. Each of the first power electronics module 91, the second power electronics module 92 and the third power electronics module 93 comprises an electric circuit (e.g., inverter or electric motor controller), wherein each electric circuit has a set of alternating current (AC) terminals (31, 32, 33) that are mounted on the circuit board 45 and that extend through one or more openings 79 in the second housing portion 10. Further, the first power electronics module 91, the second power electronics module 92, and the third power electronics module 93 share a common set of direct current (DC) terminals 30 (e.g., of the third power electronics module 93) on the exterior of the second housing portion 10. DC current terminals extend through openings 88.

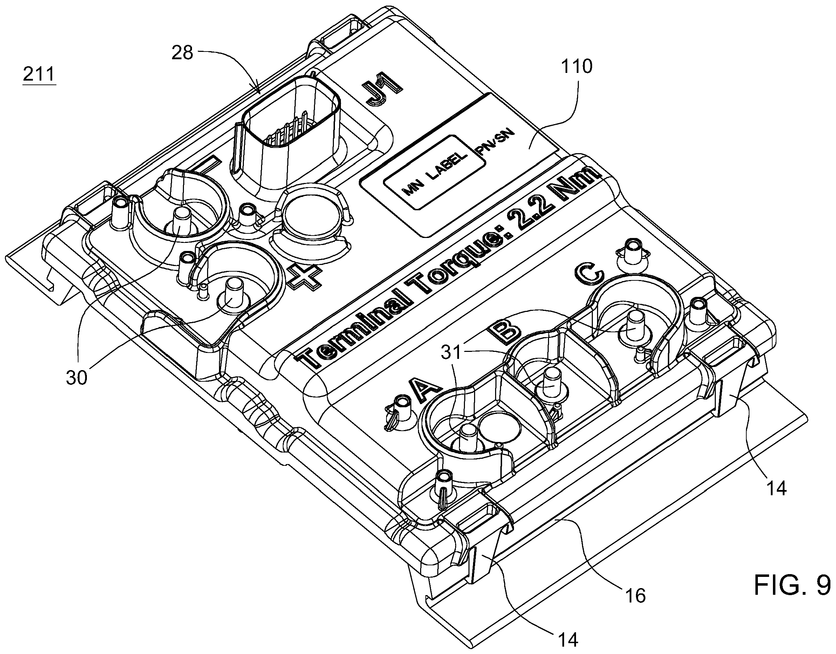

FIG. 9 is a perspective view of an upper side of a second embodiment of the electronic assembly 211. The electronic assembly 211 is similar to the electronic assembly 111, except the electronic assembly 211 comprises the first power electronics module 91 (of the respective first region) that is separated from or divided from the second power electronics module 92 of the respective second region and the third power electronics module 93 of the respective third region; hence, the electronic assembly 211 differs from the electronic assembly 111 as follows: (a) the electronic assembly 211 replaces circuit board 45 of the electronic assembly 111 with circuit board 145; (b) circuit board 145 is similar to the first power electronics module 91 of the respective first region of circuit board 45; (c) circuit board 145 is populated with similar electronic components as circuit board 45, such as heat-generating components, capacitors, and semiconductor switches; (d) the circuit board 145 has similar conductive traces and board layout to the first region of circuit board 45; (c) the first housing portion and the second housing portion are reduced in size or volume to house, enclose and protect the circuit board 145 and its electronic components from the ingress of moisture, salt, fog and debris; (f) common design feature or reusable design feature of the circuit board 145 are based on circuit board 45 (e.g., to facilitate efficient manufacturing, design and test of the electronic assembly 211). Like reference numbers in FIG. 1 and FIG. 9 indicate like elements or features.

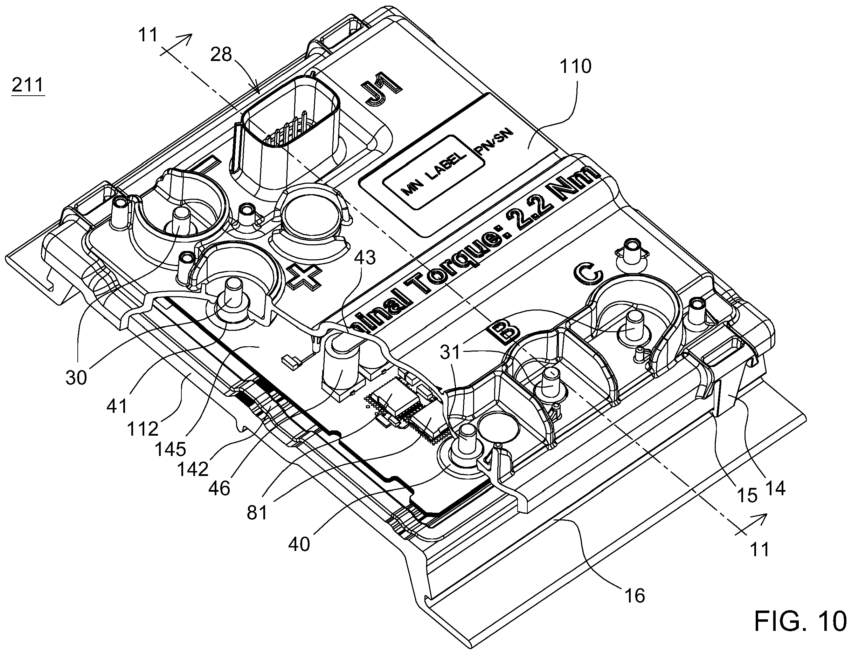

As indicated above, the first housing portion 112 of the electronic assembly 211 is similar to the first housing portion 12 of the electronic assembly 111, except the first housing portion is scaled down in size or volume to house the circuit board 145 (e.g., within a reduced cavity). Similarly, the second housing portion 110 for the electronic assembly 111 is similar to the second housing portion 10 of the electronic assembly 111, except the second housing portion is scaled down in size or volume to house the circuit board 145 (e.g., within a reduced cavity). As illustrated in FIG. 10 a perimeter seal 142 or perimeter sealant provides barrier (e.g., water resistant or watertight) and thermal interface (e.g., thermally conductive interface) between the first housing portion 112 and the second housing portion 110 while they are connected to each other. Meanwhile, a thermally conductive interface 150 provides or enhances thermal communication between one or more heat-generating components of the circuit board 145 and the ambient environment via the first housing portion 112.

FIG. 10 is a perspective view of an upper side of a second embodiment of the electronic assembly with the electronic assembly cutaway to reveal the circuit board.

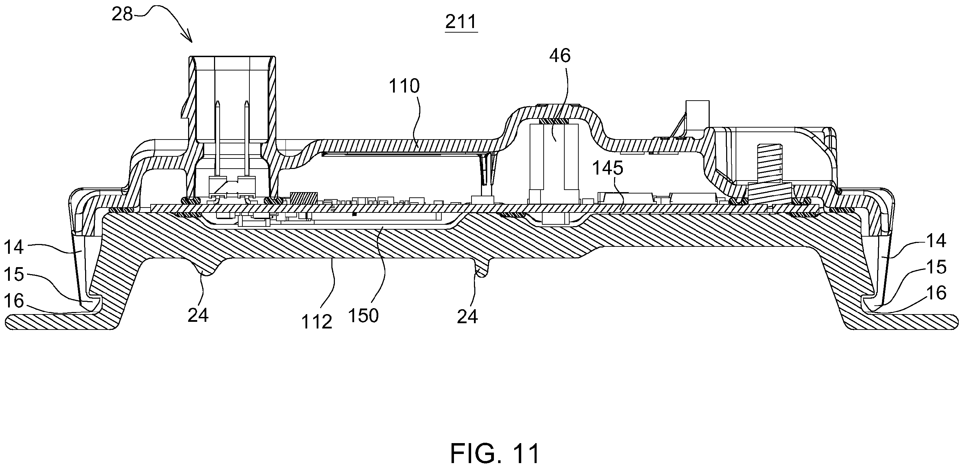

FIG. 11 is a cross-section of a second embodiment of an electronic assembly along reference line 11 of FIG. 10.

In one configuration, the first power electronics module region 91 and second power electronics module 92 share common control terminals of connectors 25, wherein the first region of the first power electronics module 91 and the second region of the second power electronics module 92 are adjacent to each other. Further, in one configuration the third region of the third power electronics module 93 is separable, divisible, or capable of removal from the first power electronics module 91; the second power electronics module 92 and the third power electronics module 93 have a separate secondary control terminals of connector 28 from the common control terminals. The first power electronics module 91 is illustrated as a separate module in FIG. 9 through 11.

For the circuit board 45, the first region, the second region and the third region may have intervening zones (e.g., dielectric strip with tolerance on each side without circuit traces and without components mounted on the dielectric strip on either side of the board) that support lateral cutting of unpopulated circuit board (e.g., raw circuit board 45 at the electronics manufacturing factory) along one or more lateral axes (76, 77) that are substantially perpendicular to a longitudinal axis 78 (of the circuit board 45 or) of the first housing portion (12, 112, 212) to produce the circuit board 145 for a dual inverter or to produce the circuit board 245 for a single inverter. The longitudinal axis 78 is typically parallel to or aligned with the longitudinal axis 75, where either can represent the longitudinal axis of the electronic assembly (11, 111, 211).

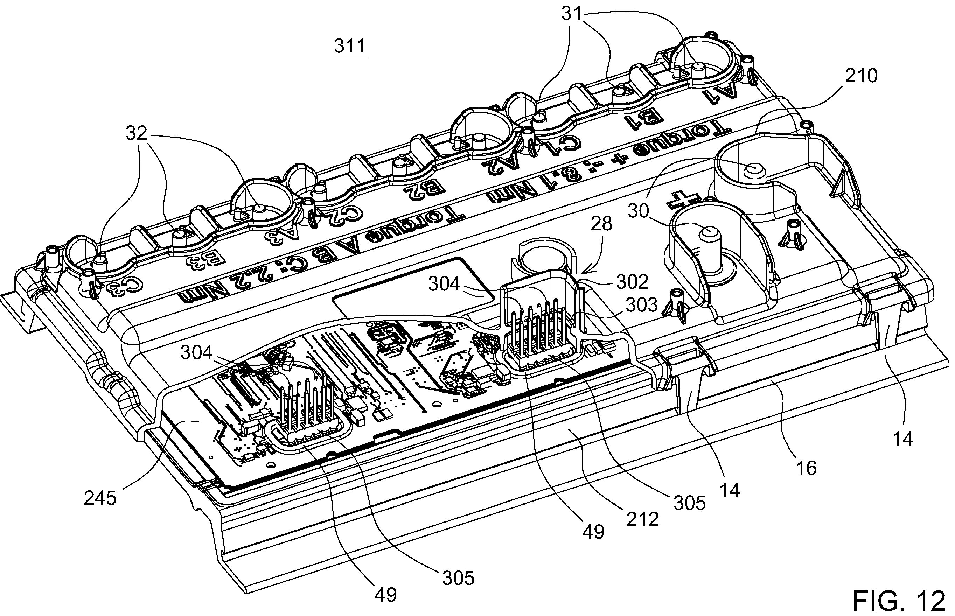

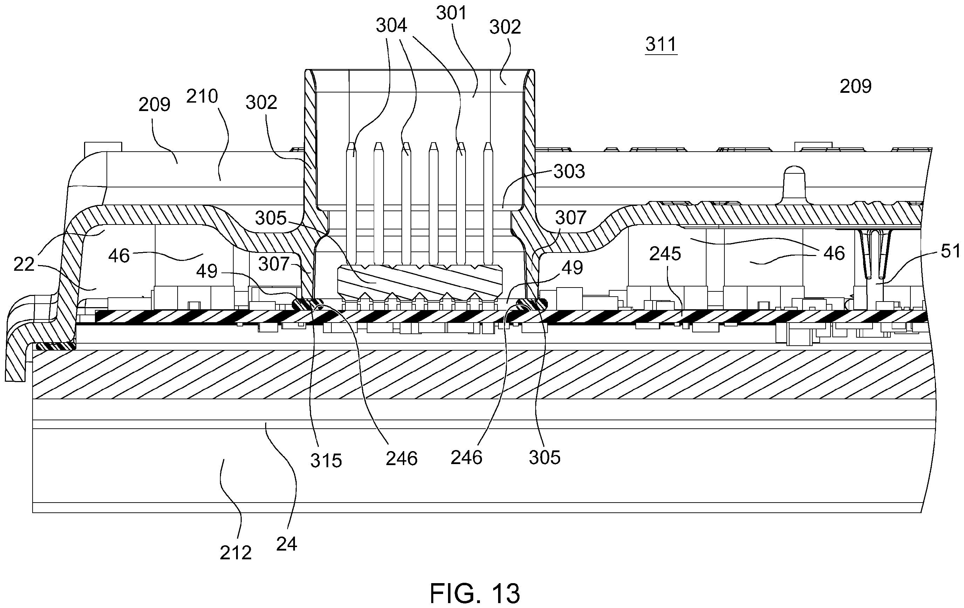

In FIG. 12 and FIG. 13, a third embodiment of an electronic assembly 311 comprises a first housing portion 212 and a second housing portion 210 coupled to the first housing portion 212 to form a cavity 23. A circuit board 245 resides within the cavity 23. The second housing portion 210 has an electrical connector 28. The electrical connector 28 comprises a first electrical connector portion that is configured to mate or be connected to a second electrical connector portion (e.g., plug or socket) to form an electrical and mechanical connection between one or more conductors. The electronical connector 28 comprises a connector body 301 with a hollow core, where the connector body 301 extends outward (or upward) from the second housing portion 210. The connector body 301 has walls 302 with a corresponding wall mating surface 315 that faces a respective circuit-board mating surface 246 of the circuit board 245. Upon cross-linking, curing or vulcanizing, the adhesive sealant 49 is configured to adhere to or adhesively bond to the wall mating surface 315 and the circuit-board mating surface 246.

In one embodiment, the connector body 301 is integral, unitary or monolithic with the second housing portion 210 or second housing body. For example, the connector body 301 is molded simultaneously or unitarily with the second housing body 209 or over-molded with the second housing body 209 to yield the complete, second housing portion 210. Over-molded means that the second housing body 209 is molded in a first molding process and then the connector body 301 is molded in a second molding process over or connected to the second housing body 209 to form the complete second housing portion 210. Further, if the second housing body 209 is composed of a thermoplastic or another suitable plastic or polymer, the second housing body 209 and the connector body 301 can be connected, welded, or fused together by heat sealing, thermal molding processes, ultrasonic welding, or other manufacturing processes. If the second housing portion 210 is composed of a thermoplastic or plastics or polymers that are not heat resistant, the second housing portion 210 would not be attached and would not be heated as part of the reflow soldering or wave soldering process.

In one embodiment, the wall mating surface 315 comprises a lower skirt of the connector body 301 that has an inwardly stepped or inwardly, downwardly tapered bottom portion 307, footprint or footing. On the circuit-board mating surface 246, a bead or ridge of adhesive sealant 49 is aligned with the tapered bottom portion, footprint or footing of the lower skirt.

One or more conductors 304 (e.g., conductive pins) extend upward within the hollow core defined by the walls 302, wherein the conductors 304 (e.g., conductive pins) are supported by one or more interior dielectric footings 305. The interior dielectric footings 305 comprise dielectric bases or dielectric spacers, wherein the conductors 304 are spaced apart from each other (e.g., laterally or coaxially) and are spaced apart from the dielectric wall 302 or walls (e.g., laterally) of the electrical connector 28.

The assembly or combination of the conductors 304 and interior dielectric footings 305 are soldered, brazed, fused, welded or connected via conductive adhesive to any of the following: (a) plated through-holes in the circuit board 245, (b) blind conductive vias in the circuit board 245, (c) conductive pads or conductive traces on the surface of the circuit board 245 (e.g., surface mounting on the circuit board) and wherein the conductors 304 are electrically connected to corresponding conductive traces on one or both sides of the circuit board 245.

In one example, conductive adhesives are composed of metal particles embedded in the plastic or polymeric matrix to support conducting of electrical energy or electrical current. If the combination of the conductors 304 and interior dielectric footings 305 are mounted on the circuit board 245, the conductors 304 are electrically connected to corresponding conductive traces on the circuit board 245, via metal plated through-holes or metallized blind vias; the collective combination (304, 305) and circuit board 245 can be wave soldered or reflow soldered in an oven without the presence of or prior to the attachment of the second housing portion 210 to the first housing portion 212.

Once or after the second housing portion 210 with an integral electrical connector (25, 28) is attached to the first housing portion 212, the adhesive sealant is cured or vulcanized and becomes adhesively bonded to the mating surfaces of dielectric wall or walls 302 of the electrical connector (25, 28) and respective circuit-board mating surfaces 246 to form a barrier to prevent the ingress of moisture, water, contaminants or debris from the within the hollow core (or interior) of the electrical connector (25, 28) from entering into the cavity 23 in which the circuit board 245 resides. The above barrier exists even when the electrical connector (e.g., 25, 28; socket or plug) is unmated or disconnected to a corresponding mating electrical connector (e.g., socket or plug). If the corresponding mating electrical connector (not shown) is inserted into the electrical connector (25, 28), a step 303 in the wall retains or stops the inserted electrical connector from further or deeper engagement that might otherwise damage the conductors or pins.

The dielectric walls 302 have a footprint, a foot portion, or footing that comprises or terminates in a wall mating surface 315. In one example, the wall mating surface 315 engages directly with the circuit-board mating surface 246. In another example, the wall mating surface 315 overlies or engages indirectly with the circuit-board mating surface 246 via an intervening layer of dielectric material, such as the dielectric adhesive 49. The footprint, foot portion or footing of the dielectric walls 302 of the electrical connector 28 are distinct from the interior dielectric footing or dielectric base of the electrical connector 28 that supports the pins or electrical connectors. For example, the interior dielectric footing 305 or dielectric base may comprise a framework to space the electrical conductors 304 (e.g., electrically conductive pins) in a matrix, one or more rows, in a coaxial pattern or in other pattern; further, the interior dielectric footing 305 may comprise a dielectric spacer, a retainer, or both for the conductors 304 (e.g., conductive pins), where the dielectric base, interior dielectric footing 305 is composed of a plastic, polymer, ceramic, resin or matrix, or a composite material that is resistant to the heat of wave soldering process and/or reflow soldering process in an oven. The composite material comprises a plastic, polymer, ceramic, resin or matrix with a fiberglass, ceramic, carbon fiber or other suitable filler.

In one embodiment as illustrated in FIG. 12 and FIG. 13, the footprint, foot portion, or wall mating surface 315 of the wall 302 has a generally rectangular perimeter, or a substantially rectangular perimeter with chamfered or rounded corners. In an alternate embodiment, the footprint, foot portion, or wall mating surface 315 of the wall 302 has a substantially elliptical perimeter, or a perimeter with another geometric shape. Here, the conductors 304 (e.g., metal or alloy conductors or conductive pins) are located inward from the footprint or foot portion of the wall 302; the conductors 304 can be located inward from the adhesive sealant (49) that is dispensed on the circuit board 245 or otherwise configured to track or register with the footprint, foot portion or wall mating surface 205 of the wall 302.

Because the sealant (e.g., 49) is dispensed to align or register with the footprint or foot portion of the wall of the connector, and adhesively bonds the wall, the footprint or the foot portion to the circuit board 245, the electrical connector 28 facilitates sealing or water resistance even when a mating connector is disconnected in a disconnected state or in an unmated state. Further, sealing against the circuit board 245 around the wall spaced apart from the pins or conductors 304 can provide comparable sealing performance to sealing around each individual pin and each individual conductor with dielectric adhesive at the interface of the circuit board 245 within the hollow core of the connector.

To the extent that the walls 302 are integrally formed or molded as part of the second housing portion 210, no sealant is required between the electrical connector 28 and the second housing portion 210. For example, the second housing portion 210 may comprise a plastic, polymer or composite housing with an integral walls 302 of the connector.

However, in some alternate embodiments, the second housing portion 210 is composed of metal, die-cast metal, aluminum, and aluminum alloy, metal or another alloy with openings to receive the electrical connector 28 with a dielectric body (e.g., walls 302 of the electrical connector 28) that are adhesively bonded to the second housing portion 210 to seal the electrical connector 28 with respect to the housing of the electronic assembly 311. For example, in the alternate embodiment the second housing portion 210 may comprise a metal or alloy body, where the dielectric electrical connector 28 or the dielectric connector body 301 of the electrical connector 28 is inserted into and sealed (e.g., via an adhesive sealant 49, a gasket, an O-ring, a grommet seal, or an elastomeric seal) to an opening in the metal or alloy body of the second housing portion 210.

In one example, the adhesive sealant 49 may comprise an elastomer, synthetic rubber, a sealant 49, or polymer or plastic. In another example, the adhesive sealant 49 is composed of one or more of the following: a silicone, a latex material, a room temperature vulcanizing (RTV) material that cures the adhesive sealant 49.

The conductors 304 or pins may be surface mounted by soldering, fusing or conductive adhesive to corresponding traces or pads on the surface of the circuit board 245. Further, the conductors 304 or pins can be arranged in a matrix or array, or another pattern. In the lower portion of the hollow core of the connector body 301, an optional dielectric barrier layer, dielectric gel (e.g., dielectric silicone gel limited to the non-contacting portions of the pins or conductors 304 that are not used to form the electrical connection in a mated electrical connector 28), or a potting compound overlies the circuit board 245 and solder joints in the lower portion of the hollow core to provide further protection against unwanted short circuits from contamination and the physical separation between adjacent pins is sufficient. Accordingly, the connector body 301 is sealed, hermetically sealed or fluidly isolated in a watertight manner with respect to the cavity 23 or the interior of the housing of the electronic assembly 311.

In this disclosure, the electrical connector 28 can be used to replace sealed headers with one or more rows of pins or conductors 304 that can be soldered (e.g., wave soldered or reflow soldered in an oven), where the exterior of the dielectric body of the sealed header is sealed to the second housing portion 210 as follows. It should be noted that traditional sealed headers are generally though-hole soldered, rather than surface-mounted soldered because the header itself can interfere with the required airflow of a convection solder oven.

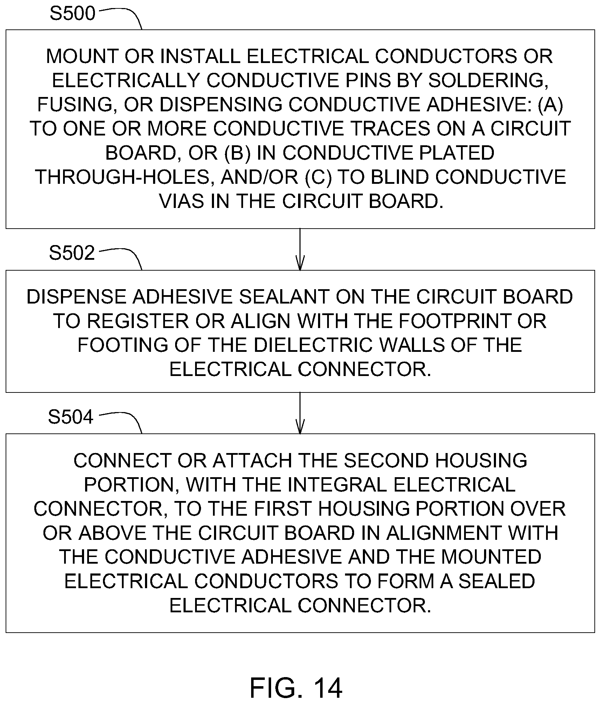

FIG. 14 discloses one embodiment of a flow chart for a method of making an electronic assembly with a sealed electrical connector. The method of FIG. 14 begins in step S500.

First, in accordance with step S500, the conductors 304 or pins with dielectric base can be soldered (e.g., wave soldered or reflow soldered in an oven), while the integral connector body 301 of the electrical connector 28 is not present and is part of the second housing portion 210. Second, in accordance with step S502, dielectric adhesive (e.g., adhesive sealant, such as silicone or RTV sealant) is dispensed on the circuit board 245 to register or align with the footprint or footing of the walls 302 of the electrical connector (25, 28). Third, in accordance with step S504, the second housing portion 210 with the integral electrical connector (25, 28) is connected to the first housing portion 212 over or above the circuit board 245 in alignment with the conductive adhesive to form a sealed electrical connector (25, 28).

In some embodiments, under step S500, the conductors 304 or pins are mounted by soldering (e.g., with solder and flux, solder paste or solder balls and flux), fusing, or dispensing conductive adhesive to or in conductive plated through-holes or to blind conductive vias in the circuit board 245. The solder forms a protective barrier to the ingress of moisture, water, salt or other contaminants into the interior of the housing or cavity 23. However, the moisture, water, salt or other contaminants can potentially still cause short-circuit connection between two or more conductors 304 or pins that are exposed, or their respective solder joints, unless dielectric barrier layer or a potting compound in the lower portion of the hollow core and the physical separation between adjacent pins is sufficient.

In this disclosure, the electrical connector is well suited for sealing or isolating the electrical connector from a remainder of the electronic assembly, such as its electrical components, electronic components and circuit traces of the circuit board that could be vulnerable to damage or reduced reliability from the ingress of moisture, water, salt, debris or other contaminants; some of which can conduct electrical energy resulting in possible electrical short circuits and others of which can corrode the conductive traces, conductive pads or leads of electrical and electronic components resulting in possible intermittent or open electrical circuits. By sealing at the circuit board a dispensed adhesive sealant (e.g., RTV sealant) can be used to form a watertight sealed electrical connector or an economical, watertight sealed electrical connector.

In this disclosure, the electronic assembly is well-suited to reduce or eliminate one or more screws, one or more deflectable spring contacts, and any attendant installation costs, that are otherwise required to create an electrical connection between a conductive trace of the circuit board and an cavity 23 (e.g., interior) of the enclosure (e.g., at electrical or chassis ground). Instead, an electrical connection is established by securing or joining the second housing portion (10, 110, 210) to the first housing portion (12, 112, 212), or vice versa, via one or more snap-fit connectors or clips, among other features to establish contact between a conductive trace on the circuit board and a corresponding conductive region of the first housing portion (12, 112, 212). For example, the enclosure facilitates the use of an extruded aluminum design for the first housing portion (12, 112, 212) without any grounding screws to connect to electrical ground or chassis ground and without any spring-biased electrical connections to connect to electrical ground or chassis ground.

While the disclosure has been illustrated and described in detail in the drawings and foregoing description, such illustration and description is to be considered as exemplary and not restrictive in character, it being understood that illustrative embodiments have been shown and described and that all changes and modifications that come within the spirit of the disclosure are desired to be protected. It will be noted that alternative embodiments of the present disclosure may not include all of the features described yet still benefit from at least some of the advantages of such features. Those of ordinary skill in the art may readily devise their own implementations that incorporate one or more of the features of the present disclosure and fall within the spirit and scope of the present invention as defined by the appended claims.

## Claims

1. An electronic assembly comprising:
a first housing portion;
a second housing portion coupled to the first housing portion to form a cavity;
a circuit board residing within the cavity;
the second housing portion having a connector body with a hollow core extending outward from the second housing portion and wherein the connector body has walls with corresponding wall mating surface that faces a respective circuit board mating surface of the circuit board;
an adhesive sealant configured to adhere to the wall and circuit board mating surfaces.

2. The electronic assembly according to claim 1 wherein the connector body is integral with the second housing body.

3. The electronic assembly according to claim 1 wherein the connector body is molded simultaneously or unitarily with the second housing body or over-molded with the second housing body.

4. The electronic assembly according to any one of claims 1 to 3 wherein the wall mating surface comprising a lower skirt of the connector body that has an inwardly stepped or inwardly tapered bottom portion.

5. The electronic assembly according to any one of claims 1 to 4 wherein a bead or ridge of adhesive sealant is aligned the tapered bottom portion of the lower skirt.

6. The electronic assembly according to any one of claims 1 to 5 wherein one or more conductors or conductive pins extend upward within the hollow core, wherein the conductors are supported by one or more dielectric footings or bases.

7. The electronic assembly according to any one of claims 1 to 6 wherein the combination of the conductors and dielectric footings are surface mounted on the circuit board, and wherein the conductors are electrically connected to corresponding conductive traces on the circuit board.

8. The electronic assembly according to any one of claims 1 to 6 wherein the combination of the conductors and dielectric footings are mounted on the circuit board, and wherein the conductors are electrically connected to corresponding conductive traces on the circuit board via plated through-holes or metallized blind vias.

9. The electronic assembly according to any one of claims 1 to 8 wherein the adhesive sealant is adhesively bonded to the wall and circuit board mating surfaces to form a barrier to prevent the ingress of moisture, water, contaminants or debris from the within the hollow core from entering into the cavity in which the circuit board resides.

10. The electronic assembly according to claim 9 wherein the barrier exists even when the connector is unmated or disconnected.

11. The electronic assembly according to any one of claims 1 to 10, wherein the circuit board comprises a first power electronics module associated with a corresponding first region of the circuit board, a second power electronics module associated with a corresponding second region of the circuit board, and a third power electronics module associated with a third region of the circuit board; each of the first power electronics module, the second power electronics module and the third power electronics module comprising an inverter, wherein each inverter has a set of alternating current terminals that are mounted on the circuit board and that extend through the second housing portion and wherein the first power electronics module, the second power electronics module, and the third power electronics module share a common set of direct current terminals on the exterior of the second housing portion.

12. The electronic assembly according to claim 11 wherein the first power electronics module and a second power electronics module share common control terminals and wherein the first power electronics module and the second power electronics module are adjacent to each other.

13. The electronic assembly according to claim 11 wherein the combination of the first power electronics module and the second power electronics module is separable or divisible from the third power electronics module; the third power electronics module having separate secondary control terminals from the common control terminals, where the first power electronics module and the second power electronics module have an integral circuit board that supports dual inverters with respective sets of alternating current terminals, the common control terminals, and direct current terminals.

14. The electronic assembly according to claim 11 wherein the first power electronics module is separable from the second power electronics module and the third power electronics module, where the first power electronics module provides a corresponding single inverter with alternating current terminals, the common control terminals, and direct current terminals.
